(19) Europäisches Patentamt
European Patent Office
Office européen des brevets

(11) **EP 2 476 002 B1**

(12) **EUROPÄISCHE PATENTSCHRIFT**

(45) Veröffentlichungstag und Bekanntmachung des Hinweises auf die Patenterteilung:
**27.05.2015 Patentblatt 2015/22**

(21) Anmeldenummer: **09778596.8**

(22) Anmeldetag: **09.09.2009**

(51) Int Cl.:
*G01R 29/16* (2006.01)   *G01R 31/02* (2006.01)
*G01R 31/08* (2006.01)   *H02H 3/08* (2006.01)
*H02H 3/38* (2006.01)   *H02H 3/40* (2006.01)
*H02H 3/42* (2006.01)

(86) Internationale Anmeldenummer:
**PCT/EP2009/006742**

(87) Internationale Veröffentlichungsnummer:
**WO 2011/029464 (17.03.2011 Gazette 2011/11)**

(54) **FEHLERERKENNUNG IN ENERGIEVERSORGUNGSNETZEN MIT UNGEERDETEM ODER GELÖSCHTEM STERNPUNKT**

FAULT DETECTION IN ENERGY SUPPLY NETWORKS HAVING AN UNEARTHED OR RESONANT-EARTHED STAR POINT

IDENTIFICATION DE DÉFAUTS DANS DES RÉSEAUX D'ALIMENTATION EN ÉNERGIE PRÉSENTANT UN POINT NEUTRE NON RELIÉ À LA TERRE OU UNE DISPARITION DU POINT NEUTRE

(84) Benannte Vertragsstaaten:
**AT BE BG CH CY CZ DE DK EE ES FI FR GB GR HR HU IE IS IT LI LT LU LV MC MK MT NL NO PL PT RO SE SI SK SM TR**

(43) Veröffentlichungstag der Anmeldung:
**18.07.2012 Patentblatt 2012/29**

(73) Patentinhaber: **Siemens Aktiengesellschaft 80333 München (DE)**

(72) Erfinder:
• **DZIENIS, Cezary**
  **13587 Berlin (DE)**
• **KEREIT, Matthias**
  **12159 Berlin (DE)**
• **STRÜCKER, Arnd**
  **27804 Berne-Bardenfleth (DE)**

(56) Entgegenhaltungen:
EP-A1- 1 598 674    EP-A2- 0 932 235
EP-A2- 1 304 580    WO-A1-01/22104
WO-A2-03/036312    WO-A2-2006/130722
DE-A1- 4 439 499    DE-B3- 10 302 451
JP-A- 2004 023 876    JP-A- 2004 239 899
JP-A- 2005 192 305    JP-A- 2006 010 608
JP-A- 2009 186 266    US-A- 5 661 664
US-A1- 2005 280 966

• MU LONGHUA ET AL: "Selective ground-fault protection using an adaptive algorithm model in neutral ungrounded power systems" POWER SYSTEM TECHNOLOGY, 2000. PROCEEDINGS. POWERCON 2000. INTERNATION AL CONFERENCE ON 4-7 DECEMBER 2000, PISCATAWAY, NJ, USA,IEEE, Bd. 3, 4. Dezember 2000 (2000-12-04), Seiten 1689-1693, XP010528864 ISBN: 978-0-7803-6338-0

**Beschreibung**

Die Erfindung betrifft ein Verfahren zum Bestimmen eines erdschlussbehafteten Leitungsabschnitts in einem dreiphasigen elektrischen Energieversorgungsnetz mit isoliertem oder gelöschtem Sternpunkt, bei dem an beiden Enden des Leitungsabschnitts an jeweils einer Messstelle mittels eines elektrischen Schutzgerätes eine Nullsystemspannung und ein Nullsystemstrom erfasst werden und aus der Nullsystemspannung und dem Nullsystemstrom eine Richtungsinformation gewonnen wird, die angibt, ob ein Erdschluss in Vorwärts- oder in Rückwärtsrichtung bezüglich der jeweiligen Messstelle liegt.

Außerdem betrifft die Erfindung ein elektrisches Schutzgerät, das zur Überwachung eines Leitungsabschnitts eines dreiphasigen elektrischen Energieversorgungsnetzes an einer Messstelle an einem Ende des Leitungsabschnitts angeordnet ist und eine Messeinrichtung zur Erfassung einer Nullsystemspannung und eines Nullsystemstroms an der Messstelle aufweist.

Elektrische Erdschlüsse, also fehlerhafte niederohmige elektrische Verbindungen eines Phasenleiters mit Erde, bilden den Großteil der Fehler in dreiphasigen elektrischen Energieversorgungsnetzen. Sie werden beispielsweise durch Kontakt mit an die Leitung herangewachsenen Bäumen oder durch Blitzschlag hervorgerufen oder beruhen auf einer Zerstörung der Leitung mit anschließender Erdberührung.

Elektrische Energieversorgungsnetze können mit unterschiedlichen Erdungsvarianten bezüglich ihres Sternpunktes betrieben werden. Energieversorgungsnetze mit geerdetem Sternpunkt, die eine wirksame elektrische Verbindung zwischen ihrem Sternpunkt und Erde aufweisen, gewährleisten eine hohe Symmetrie zwischen den einzelnen Phasenströmen und -spannungen, jedoch fließen bei dieser Variante im Falle eines einzelnen Erdschlusses aufgrund der elektrisch geschlossenen Leiter-Erde-Schleife hohe Fehlerströme, die sofort zu einer Abschaltung der fehlerbehafteten Leitung führen müssen. Daher werden Energieversorgungsnetze in bestimmten Spannungsebenen (z.B. im Bereich der Mittelspannung zwischen 6kV und 110kV) häufig mit isoliertem oder gelöschtem Sternpunkt betrieben. Bei einem isolierten Sternpunkt besteht keine wirksame elektrische Verbindung des Sternpunktes mit Erde, während bei einem gelöschten bzw. kompensierten Sternpunkt eine Induktivität, z.B. eine sogenannte "Petersenspule" in der Verbindung zwischen Sternpunkt und Erde angeordnet ist. Einpolige Erdschlüsse führen in solchen Netzen nicht zu einem dauerhaften Kurzschlussstrom. In der Regel erfolgt daher in isolierten oder gelöschten Energieversorgungsnetzen bei einfachen Erdschlüssen keine Schutzauslösung, da das Energieversorgungsnetz mit einem einfachen Erdschluss weiterbetrieben werden kann. Der Netzbetreiber ist jedoch verpflichtet, den fehlerhaften Leitungsabschnitt zu bestimmen und den Schaden schnellstmöglich zu beheben.

Ein Verfahren der eingangs genannten Art ist beispielsweise aus der europäischen Patentschrift EP 144 675 B1 bekannt. Gemäß dem bekannten Verfahren werden zur Erkennung eines Fehlers auf einer elektrischen Übertragungsleitung mit einem sogenannten Richtelement eine Nullsystemspannung und ein Nullsystemstrom erfasst, aus denen eine Nullsystem-Impedanz gebildet wird. Der Wert der Nullsystem-Impedanz wird mit zwei Schwellenwerten verglichen und es wird eine Richtungsinformation gebildet, die einen Fehler in Vorwärtsrichtung angibt, wenn die Nullsystem-Impedanz über einem oberen Schwellenwert liegt, und einen Fehler in Rückwärtsrichtung angibt, wenn die Nullsystem-Impedanz unter einem unteren Schwellenwert liegt. Das bekannte Verfahren ist aufgrund des Vergleichs der Nullsystem-Impedanz mit einem oberen und einem unteren Schwellenwert vergleichsweise aufwändig durchzuführen.

Eine andere Möglichkeit zur Erkennung von Erdschlüssen ist die Verwendung einer sogenannten KNOSPE-Schaltung (KNOSPE = <u>k</u>urze <u>n</u>iederohmige <u>S</u>ternpunkt-<u>E</u>rdung). Die Verwendung der KNOSPE-Schaltung geht beispielsweise aus dem Fachbuch von W. DOEMELAND "Schutztechnik - Grundlagen, Schutzsysteme, Inbetriebsetzung", 6., aktualisierte und erweiterte Auflage, VDE Verlag, 1997, ab Seite 341 im Kapitel 10.9 "Kurzzeitig niederohmige Sternpunkt-Schaltung" hervor. Bei diesem Verfahren wird der Sternpunkt des Energieversorgungsnetzes kurzzeitig über einen ohmschen Widerstand geerdet. Nach dem Erden fließt ein Kurzschlussstrom und die Leitungsschutzgeräte, wie z.B. Distanzschutzgeräte und/oder Differentialschutzgeräte, können aufgrund des signifikanten Fehlerstromes Anregesignale oder Auskommandos bilden. Der Erdschluss befindet sich dann auf der abgeschalteten Leitung. Wenn nicht abgeschaltet werden soll, kann wahlweise auch ein Fehlerortungsverfahren zur Bestimmung der Erdschlussstelle eingesetzt werden. Ein wesentlicher Nachteil des Verfahrens besteht darin, dass kurzzeitig ein hoher Kurzschlussstrom fließt und der Netzbetrieb ggf. durch eine Schalthandlung negativ beeinflusst wird.

Der Erfindung liegt die Aufgabe zugrunde, ein vergleichsweise einfaches Verfahren sowie ein Schutzgerät zum Bestimmen eines erdschlussbehafteten Leitungsabschnitts in einem dreiphasigen elektrischen Energieversorgungsnetz mit isoliertem oder gelöschtem Sternpunkt anzugeben, um die erdschlussbehaftete Leitung zu bestimmen, ohne Teile des elektrischen Energieversorgungsnetzes abschalten zu müssen.

Hinsichtlich des Verfahrens wird die genannte Aufgabe durch ein Verfahren der eingangs angegebenen Art gelöst, bei dem mit den Schutzgeräten an beiden Enden des Leitungsabschnitts aus der Nullsystemspannung und dem Nullsystemstrom eine komplexe Nullsystem-Scheinleistung bestimmt wird, aus dem Vorzeichen eines Anteils der komplexen Nullsystem-Scheinleistung die Richtungsinformation abgeleitet wird, die Richtungsinformationen von beiden Enden miteinander verglichen werden und ein auf dem Leitungsabschnitt liegender Erdschluss erkannt wird, wenn beide Richtungsinformationen eine Vorwärtsrichtung angeben und ein außerhalb des Leitungsabschnitts liegender Erdschluss erkannt wird, wenn zumindest eine Richtungsinformation eine Rückwärtsrichtung angibt.

Ein Vorteil des erfindungsgemäßen Verfahrens besteht darin, dass vergleichsweise einfach, nämlich durch bloße Untersuchung des Vorzeichens eines Anteils der komplexen Nullsystem-Scheinleistung die gewünschte Richtungsinformation abgeleitet wird. Als Anteile der komplexen Nullsystem-Scheinleistung werden hierbei der Realteil und der Imaginärteil der Nullsystemscheinleistung angegeben. Bei der Richtungsinformation kann es in der einfachsten Form um ein binäres Signal handeln, dessen einer Zustand die Vorwärtsrichtung und dessen anderer Zustand die Rückwärtsrichtung angibt. "Vorwärts" bedeutet hierbei, dass das messende Schutzgerät den Fehler aus der Richtung des überwachten Leitungsabschnitts erkennt, "rückwärts" bedeutet entsprechend, dass das messende Schutzgerät den Fehler aus der anderen Richtung (also "hinter" der Messstelle) erkennt.

Ein weiterer Vorteil besteht darin, dass bei Kenntnis beider Richtungsinformationen die Möglichkeit besteht, die Lage eines Erdschlusses in dem elektrischen Energieversorgungsnetz anzugeben, ohne einen Teil des elektrischen Energieversorgungsnetzes abschalten zu müssen.

Eine vorteilhafte Ausführungsform des erfindungsgemäßen Verfahrens besteht darin, dass bei einem Energieversorgungsnetz mit isoliertem Sternpunkt die jeweilige Richtungsinformation gebildet wird, indem der Imaginärteil der Nullsystem-Scheinleistung unter Bildung einer Nullsystem-Blindleistung bestimmt wird und bei positivem Vorzeichen der Nullsystem-Blindleistung die Vorwärtsrichtung erkannt wird und bei negativem Vorzeichen der Nullsystem-Blindleistung die Rückwärtsrichtung erkannt wird. Auf diese Weise kann vergleichsweise einfach für ein Energieversorgungsnetz mit isoliertem Sternpunkt die Richtungsinformation gebildet werden.

Gemäß einer anderen Ausführungsform des erfindungsgemäßen Verfahrens kann vorgesehen sein, dass bei einem Energieversorgungsnetz mit gelöschtem Sternpunkt die jeweilige Richtungsinformation gebildet wird, indem der Realteil der Nullsystem-Scheinleistung unter Bildung einer Nullsystem-Wirkleistung bestimmt wird und bei negativem Vorzeichen der Nullsystem-Wirkleistung die Vorwärtsrichtung erkannt wird und bei positivem Vorzeichen der Nullsystem-Wirkleistung die Rückwärtsrichtung erkannt wird. Hierdurch kann vergleichsweise einfach für ein Energieversorgungsnetz mit gelöschtem Sternpunkt die Richtungsinformation gebildet werden.

Eine weitere vorteilhafte Ausführungsform des erfindungsgemäßen Verfahrens sieht vor, dass die Richtungsinformationen beider Enden an eine übergeordnete Datenverarbeitungseinrichtung übertragen werden und die übergeordnete Datenverarbeitungseinrichtung den Vergleich der Richtungsinformationen durchführt und ein Fehlersignal abgibt, das einen auf dem Leitungsabschnitt oder außerhalb des Leitungsabschnitts liegenden Erdschluss angibt. In diesem Fall kann die übergeordnete Datenverarbeitungseinrichtung sehr einfach durch Vergleich der beiden Richtungsinformationen eine Entscheidung darüber treffen, ob der Fehler auf dem überwachten Leitungsabschnitt liegt oder nicht.

Alternativ kann auch vorgesehen sein, dass an ein ausgewähltes der beiden Schutzgeräte die Richtungsinformation des anderen Schutzgerätes übertragen wird und das ausgewählte Schutzgerät den Vergleich der Richtungsinformationen durchführt und ein Fehlersignal abgibt, das einen auf dem Leitungsabschnitt oder außerhalb des Leitungsabschnitts liegenden Erdschluss angibt. Bei dieser Ausführungsform wird das entsprechende Fehlersignal folglich vorteilhaft durch eines der (ohnehin vorhandenen) Schutzgeräte erzeugt, so dass keine zusätzlichen Einrichtungen zum Vergleich der Richtungsinformationen und zur Abgabe des Fehlersignals notwendig sind.

Ferner kann alternativ dazu auch vorgesehen sein, dass beide Richtungsinformationen zu dem jeweiligen Schutzgerät am gegenüberliegenden Ende des Leitungsabschnitts übertragen werden und jedes Schutzgerät den Vergleich der Richtungsinformationen durchführt und ein Fehlersignal abgibt, das einen auf dem Leitungsabschnitt oder außerhalb des Leitungsabschnitts liegenden Erdschluss angibt. Da in diesem Fall die Richtungsinformationen beider Schutzgeräte zum jeweils entfernten Leitungsende übertragen und dort mit der lokal vorliegenden Richtungsinformation verglichen werden, kann das Fehlersignal mit größerer Sicherheit auch dann gebildet werden, wenn eines der beiden Schutzgeräte eine Fehlfunktion bezüglich der Bestimmung des Fehlersignals aufweist oder die Datenübertragung in einer Richtung gestört ist.

Für den Fall, dass der Vergleich der Richtungsinformationen und die Bildung des Fehlersignals von einem oder beiden Schutzgeräten durchgeführt werden, kann in vorteilhafter Weise gemäß einer weiteren Ausführungsform des erfindungsgemäßen Verfahrens auch vorgesehen sein, dass die Schutzgeräte Differentialschutzgeräte sind und zur Übertragung der jeweiligen Richtungsinformation eine ohnehin zur Durchführung des Differentialschutzes vorhandene Datenübertragungsleitung verwendet wird. Differentialschutzgeräte werden häufig zur Überwachung von Leitungsabschnitten eines elektrischen Energieversorgungsnetzes eingesetzt, und da zur Durchführung des Differentialschutzverfahrens ohnehin eine Datenübertragungsleitung zwischen den Differentialschutzgeräten an beiden Enden des Leitungsabschnittes vorhanden ist, kann das beschriebene Verfahren ohne Kosten und Aufwand für zusätzliche Komponenten durchgeführt oder sogar in ein bestehendes Differentialschutzsystem integriert werden.

Schließlich sieht eine vorteilhafte Ausführungsform des erfindungsgemäßen Verfahrens vor, dass bei einem elektrischen Energieversorgungsnetz mit mehreren Leitungsabschnitten für jedes Ende eines jeden Leitungsabschnitts die Richtungsinformation gebildet wird und aus einem Vergleich aller Richtungsinformation derjenige Leitungsabschnitt als von dem Erdschluss behaftet angegeben wird, an dessen Enden die Richtungsinformationen jeweils eine Vorwärtsrichtung angeben. Hierdurch kann auch bei einem vergleichsweise komplex aufgebauten elektrischen Energieversorgungsnetz mit mehreren Leitungsabschnitten die Lokalisierung eines Erdschlusses in vergleichsweise einfache Weise durchgeführt werden.

Hinsichtlich des elektrischen Schutzgerätes wird die oben genannte Aufgabe durch ein Schutzgerät der eingangs genannten Art gelöst, dass eine Auswertungseinrichtung aufweist, die zur Bestimmung einer Richtungsinformation entsprechend einem der Verfahren gemäß einem der Patentansprüche 1 bis 3 eingerichtet ist.

Mit einem solchen Schutzgerät kann in einfacher Weise und ohne Teile des elektrischen Energieversorgungsnetzes abschalten zu müssen, eine Erkennung und Lokalisierung eines Erdschlusses vorgenommen werden.

Eine vorteilhafte Weiterbildung des erfindungsgemäßen elektrischen Schutzgerätes sieht vor, dass es eine Kommunikationseinrichtung aufweist, die zur Übertragung einer Richtungsinformation an ein anderes elektrisches Schutzgerät oder eine übergeordnete Datenverarbeitungseinrichtung eingerichtet ist.

Eine weitere vorteilhafte Ausführungsform des erfindungsgemäßen Schutzgerätes sieht außerdem vor, dass es eine Kommunikationseinrichtung aufweist, die zum Empfang einer Richtungsinformation von einem anderen elektrischen Schutzgerät eingerichtet ist, und die Auswertungseinrichtung zum Vergleich der eigenen und der empfangenen Richtungsinformation und zur Bildung eines Fehlersignals eingerichtet ist, wobei das Fehlersignal einen auf dem Leitungsabschnitt oder außerhalb des Leitungsabschnitts liegenden Erdschluss angibt.

Um eine Erkennung und Lokalisierung eines Erdschlusses auch ohne zusätzlichen Aufwand für weitere Komponenten durchführen zu können, sieht eine weitere vorteilhafte Ausführungsform des elektrischen Schutzgerätes schließlich vor, dass das Schutzgerät ein Differentialschutzgerät ist und die Kommunikationseinrichtung zur Übertragung oder zum Empfang einer Richtungsinformation mit einer ohnehin zur Durchführung des Differentialschutzes vorhandenen Datenübertragungsleitung in Verbindung steht.

Die Erfindung wird im Folgenden anhand von Ausführungsbeispielen näher erläutert. Hierzu zeigen

Fig. 1    eine schematische Ansicht eines durch zwei Schutzgeräte überwachten elektrischen Leitungsabschnittes,

Fig. 2    ein beispielhaftes Ersatzschaltbild eines fehlerfreien Leitungsabschnittes eines gelöschten Energieversorgungsnetzes,

Fig. 3    ein beispielhaftes Ersatzschaltbild eines erdschlussbehafteten Leitungsabschnitts eines gelöschten Energieversorgungsnetzes,

Fig. 4    den Verlauf der Nullsystem-Wirkleistung im Falle eines Erdschlusses auf dem überwachten Leitungsabschnitt eines gelöschten Energieversorgungsnetzes,

Fig. 5    ein weiteres Ersatzschaltbild eines Leitungsabschnitts eines gelöschten Energieversorgungsnetzes mit einem außerhalb des Leitungsabschnitts liegenden Erdschluss,

Fig. 6    den Verlauf der Nullsystem-Wirkleistung im Falle eines außerhalb des Leitungsabschnitts liegenden Erdschlusses bei einem gelöschten Energieversorgungsnetz,

Fig. 7    ein beispielhaftes Ersatzschaltbild eines erdschlussbehafteten Leitungsabschnitts eines isolierten Energieversorgungsnetzes,

Fig. 8    den Verlauf der Nullsystem-Blindleistung im Falle eines auf dem Leitungsabschnitt liegenden Erdschlusses bei einem isolierten Energieversorgungsnetz,

Fig. 9    den Verlauf der Nullsystem-Blindleistung im Falle eines außerhalb des Leitungsabschnitts liegenden Erdschlusses bei einem isolierten Energieversorgungsnetz, und

Fig. 10    ein mehrere überwachte Leitungsabschnitte aufweisendes isoliertes Energieversorgungsnetz.

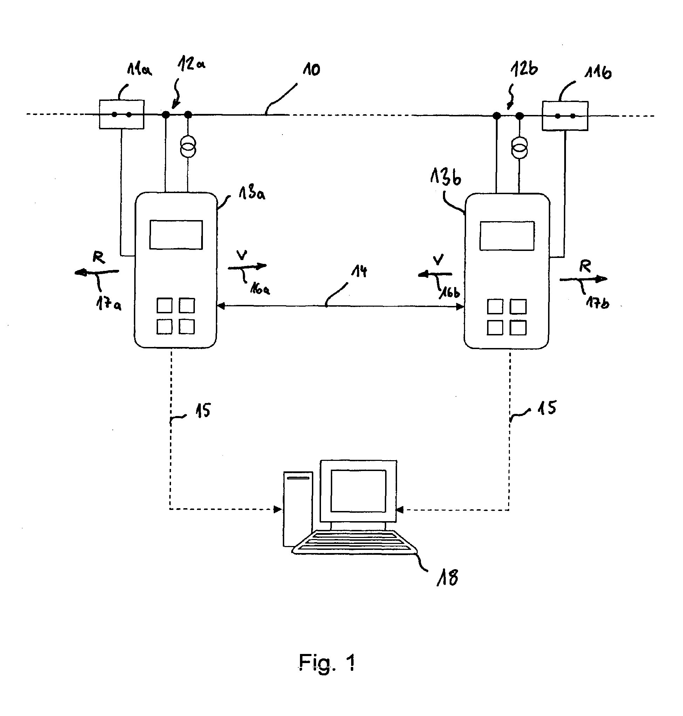

Fig. 1 zeigt einen Leitungsabschnitt 10 eines im Übrigen nicht weiter dargestellten elektrischen Energieversorgungsnetzes mit isoliertem oder gelöschtem Sternpunkt. Der Leitungsabschnitt 10 wird an seinen Enden durch elektrische Leistungsschalter 11a und 11b begrenzt. Obwohl der Leitungsabschnitt 10 in Fig. 1 der Einfachheit halber in einphasiger Darstellung gezeigt ist, handelt es sich bei dem Leitungsabschnitt 10 um einen dreiphasigen Leitungsabschnitt eines dreiphasigen elektrischen Energieversorgungsnetzes.

An den Enden des Leitungsabschnittes 10 sind ferner Messstellen 12a und 12b vorgesehen, an denen für jede Phase des Leitungsabschnitts 10 mittels entsprechender Messwandler Phasenströme und Phasenspannungen erfasst und elektrischen Schutzgeräten 13a und 13b zugeführt werden.

Im Folgenden wird ein Verfahren zur Erkennung der Lage eines Einfach-Erdschlusses in dem Energieversorgungsnetz erläutert. Ein solcher Einfach-Erdschluss, also unerwünschte eine elektrische Verbindung zwischen einem Phasenleiter und Erde, stellt einen der häufigsten in einem elektrischen Energieversorgungsnetz mit Freileitungen auftretenden Fehler dar und kann beispielsweise durch Berührung eines Phasenleiters durch einen Baum, durch Wind oder Blitzschlag herbeigeführt werden. Bei einem elektrischen Energieversorgungsnetz mit isoliertem Sternpunkt besteht keine wirksame elektrische Verbindung zwischen dem Sternpunkt des Energieversorgungsnetzes und Erde, so dass im Falle eines einzelnen Erdschlusses auf einem Leitungsabschnitt des elektrischen Energieversorgungsnetzes kein relevanter Kurzschlussstrom fließt und das elektrische Energieversorgungsnetz ohne Abschaltung durch die Schutzgeräte 13a, 13b weiter betrieben werden kann. Bei einem elektrischen Energieversorgungsnetz mit einem gelöschten Sternpunkt ist der Sternpunkt des elektrischen Energieversorgungsnetzes über eine induktive Komponente, z.B. eine sogenannte PetersenSpule, mit Erde verbunden, um die stark kapazitiven Anteile eines im Falle eines einfachen Erdschlusses auf einem Leitungsabschnitt des elektrischen Energieversorgungsnetzes fließenden Fehlerstroms durch ihre induktiven Anteile zu kompensieren, so dass nur ein vernachlässigbar kleiner Fehlerstrom fließt, und die Schutzgeräte 13a, 13b den Fehler nicht abschalten müssen. In beiden Fällen muss jedoch der Betreiber des Energieversorgungsnetz über das Vorhandensein eines einfachen Erdschlusses informiert werden, um den Fehler beheben zu können, bevor ein weiterer Erdschluss in dem elektrischen Energieversorgungsnetz auftritt, da über die dann vorhandene geschlossene Leiter-Erde-Schleife ein relevanter Kurzschlussstrom fließen würde, der ein sofortiges Abschalten des fehlerbehafteten Teils des Energieversorgungsnetzes notwendig machen würde.

Mit den Schutzgeräten 13a und 13b wird aus den erfassten Phasenspannungen und Phasenströmen jeweils eine Nullsystemspannung und ein Nullsystemstrom bestimmt. Aus dem Nullsystemstrom und der Nullsystemspannung wird schließlich eine komplexe Nullsystem-Scheinleistung ermittelt. Abhängig von der Art der Sternpunkterdung (gelöscht oder isoliert) wird in den Schutzgeräten 13a und 13b aus dem Vorzeichen eines Anteils der Nullsystem-Scheinleistung (Realteil oder Imaginärteil) eine Richtungsinformation abgeleitet, die angibt, ob ein Erdschluss von dem jeweiligen Schutzgerät 13a, 13b aus gesehen in - durch Pfeile 16a, 16b angegebener - Vorwärtsrichtung "V" (in der Richtung des überwachten Leitungsabschnitts 10) oder in - durch Pfeile 17a, 17b angegebener - Rückwärtsrichtung "R" (in dem Leitungsabschnitt 10 entgegengesetzter Richtung) erkannt wird.

Bei dieser Methode handelt sich mit anderen Worten um eine Auswertung der Scheinleistung, die für das Nullsystem während eines einpoligen Erdschlusses gemessen wird. Hierbei ist abhängig von der Erdungsart des Energieversorgungsnetzes ein entsprechender Teil der komplexen Nullsystem-Scheinleistung in Betracht zu ziehen. Will man die Fehlerrichtung für das gelöschte bzw. kompensierte Netz bestimmen, wird der Realteil der Nullsystem-Scheinleistung (die Nullsystem-Wirkleistung) analysiert. Im gelöschten Netz gibt die ermittelte Richtungsinformation eine Vorwärtsrichtung an, wenn die Wirkleistung des Nullsystems negativ ist; eine Rückwärtsrichtung wird entsprechend erkannt, wenn die Wirkleistung des Nullsystems positiv ist. Hingegen wird bei einem isolierten Netz der Imaginärteil der Nullsystem-Scheinleistung (die Nullsystem-Blindleistung) ausgewertet. Im isolierten Netz gibt die Richtungsinformation eine Vorwärtsrichtung an, wenn die Blindleistung des Nullsystems positiv ist; eine Rückwärtsrichtung wird entsprechend erkannt, wenn die Blindleistung des Nullsystems negativ ist.

Die ermittelten Richtungsinformationen können beispielsweise als Binärsignale oder in Form von Datentelegrammen von den Schutzgeräten 13a, 13b bereitgestellt werden und müssen zur Auswertung, ob der Fehler auf dem Leitungsabschnitt 10 oder außerhalb des Leitungsabschnitts vorliegt, zusammengeführt und miteinander verglichen werden. Zu diesem Zweck kann z.B. über eine zwischen den Schutzgeräten 13a, 13b vorhandene Datenübertragungsleitung 14 zu einem ausgewählten der beiden Schutzgeräte, beispielsweise dem Schutzgerät 13a, die Richtungsinformation des anderen Schutzgerätes (in diesem Fall Schutzgerät 13b) übermittelt werden, indem das Schutzgerät 13b die von ihm ermittelte Richtungsinformation über eine Kommunikationseinrichtung an die Datenübertragungsleitung 14 abgibt und die Richtungsinformation des Schutzgerätes 13b an das ausgewählte Schutzgerät 13a übertragen wird. Das ausgewählte Schutzgerät 13a vergleicht in diesem Fall die lokal vorhandene Richtungsinformation mit der von dem anderen Schutzgerät 13b empfangenen Richtungsinformation und gibt ein Fehlersignal ab, das entweder einen Erdschluss auf dem Leitungsabschnitt 10 angibt, wenn beide Richtungsinformationen eine Vorwärtsrichtung angeben, oder einen Erdschluss außerhalb des Leitungsabschnitts 10 angibt, wenn zumindest eine der beiden Richtungsinformationen eine Rückwärtsrichtung angibt.

Die Richtungsinformationen können alternativ auch von jedem der beiden Schutzgeräte 13a bzw. 13b an das jeweils andere Schutzgerät 13b bzw. 13a am jeweils anderen Ende des Leitungsabschnitts 10 übertragen werden. In diesem Fall wird das Fehlersignal von jedem der beiden Schutzgeräte 13a und 13b anhand der Richtungsinformationen erzeugt.

Ein Fehlersignal kann lokal an dem entsprechenden Schutzgerät angezeigt werden und/oder an eine übergeordnete Stationsleitstelle oder Netzleitstelle weitergeleitet und dort dem Betreiber des elektrischen Energieversorgungsnetzes ausgegeben werden.

Handelt es sich bei den Schutzgeräten 13a, 13b um Differentialschutzgeräte, wie sie häufig zur Überwachung von Leitungsabschnitten eingesetzt werden, so ist für die Durchführung des Differentialschutzes bereits eine Datenübertragungsleitung vorhanden, die vorteilhaft zur Übertragung der jeweiligen Richtungsinformation mit ausgenutzt werden kann.

Alternativ kann schließlich vorgesehen sein, dass die Richtungsinformationen der Schutzgeräte 13a, 13b über eine weitere Datenübertragungsleitung 15 an eine übergeordnete Datenverarbeitungseinrichtung 18, beispielsweise eine Datenverarbeitungseinrichtung einer Stationsleitstelle oder einer Netzleitstelle, übermittelt werden und der Vergleich der Richtungsinformationen und die Bildung des Fehlersignals von der übergeordneten Datenverarbeitungseinrichtung 18 durchgeführt werden.

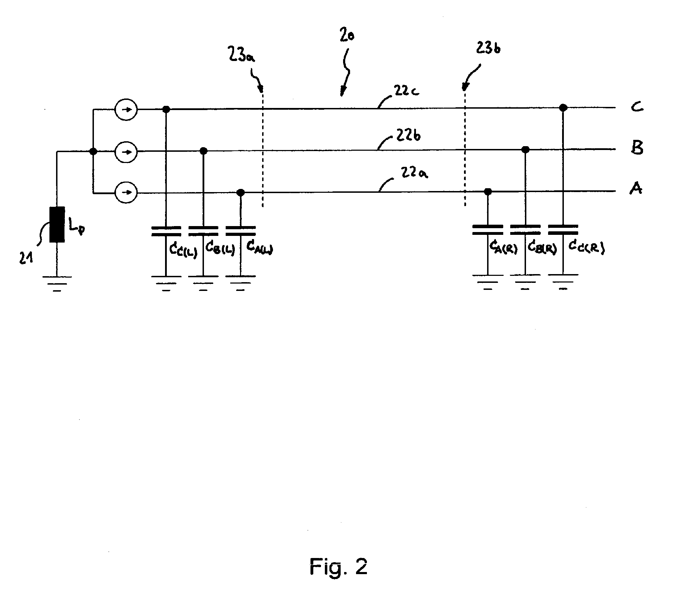

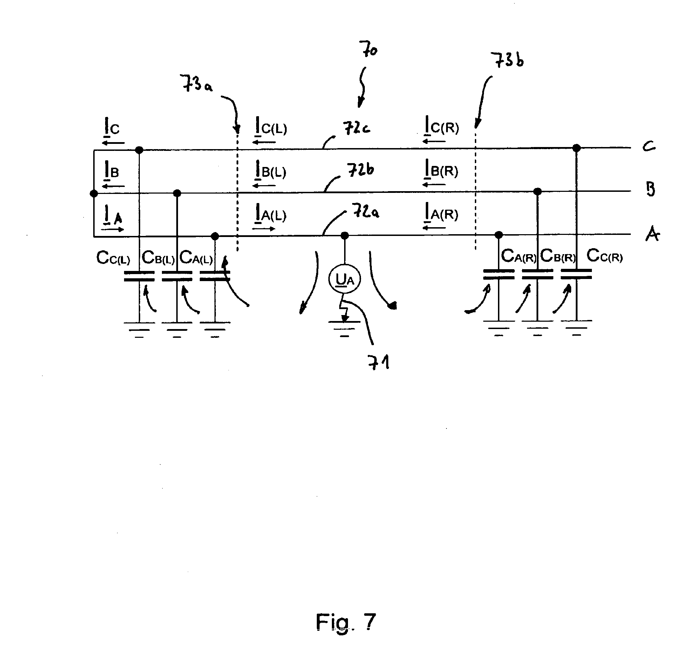

Im Folgenden soll näher auf die Bestimmung der Richtungsinformation bei den unterschiedlichen Netzarten (gelöscht bzw. isoliert) eingegangen werden. Hierfür wird die Vorgehensweise für ein elektrisches Energieversorgungsnetz mit gelöschtem Sternpunkt anhand der Figuren 2 bis 6 beschrieben, während die Vorgehensweise im Falle eines elektrischen Energieversorgungsnetzes mit einem isolierten Sternpunkt anhand der Figuren 7 bis 9 dargestellt wird.

In Figur 2 ist ein schematisches Ersatzschaltbild eines Leitungsabschnittes 20 eines gelöschten Netzes dargestellt. Zur Vereinfachung wird für das gelöschte Netz eine Stichleitung angenommen. Das charakteristische Element, das ein solches Netz von anderen Netztypen unterscheidet, ist eine Kompensationsspule 21 (z.B. Petersenspule) mit der Induktivität $L_P$, die an der Seite der Einspeisung als Erdung angeschlossen ist. Die Kompensationsspule 21 kompensiert die sich während eines Kurzschlusses bildenden kapazitiven Ströme. Dadurch sorgt sie auch für die Löschung eines Lichtbogens, der an der Kurzschlussstelle entsteht. Dank dieser Eigenschaft können solche Netze weiterhin betrieben werden, ohne die fehlerbehafteten Netzbereiche auszuschalten.

Der Leitungsabschnitt 20 umfasst drei Phasenleiter, nämlich Phasenleiter "A" 22a, Phasenleiter "B" 22b und Phasenleiter "C" 22c, deren Kapazitäten $C_{A(L)}$, $C_{B(L)}$, $C_{C(L)}$ und $C_{A(R)}$, $C_{B(R)}$ und $C_{C(R)}$ in dem Ersatzschaltbild gemäß Fig. 2 dargestellt sind. Die Indizes A, B, C repräsentieren in diesem Fall den jeweiligen Phasenleiter 22a, 22b, 22c, während die eingeklammerten Indizes (L) für die Messstelle 23a am linken Ende des Leitungsabschnitts 20 bzw. (R) für die Messstelle 23b am rechten Ende des Leitungsabschnitts 20 stehen. An den beiden Messstellen 23a, 23b sind die - in Figur 2 nicht gezeigten - Schutzgeräte angeordnet.

Die in Figur 2 dargestellte Situation stellt den normalen fehlerfreien Betrieb dar. Mit Hilfe dieses Ersatzschaltbildes können die regulären Lastflüsse berechnet werden. Im symmetrischen Betrieb werden keine Nullsystemgrößen erfasst. Daher beträgt die Nullsystem-Scheinleistung im fehlerfreien Fall null. In der Realität treten zwar immer Unsymmetrien im Netz auf, diese sind jedoch sehr klein und können somit vernachlässigt werden.

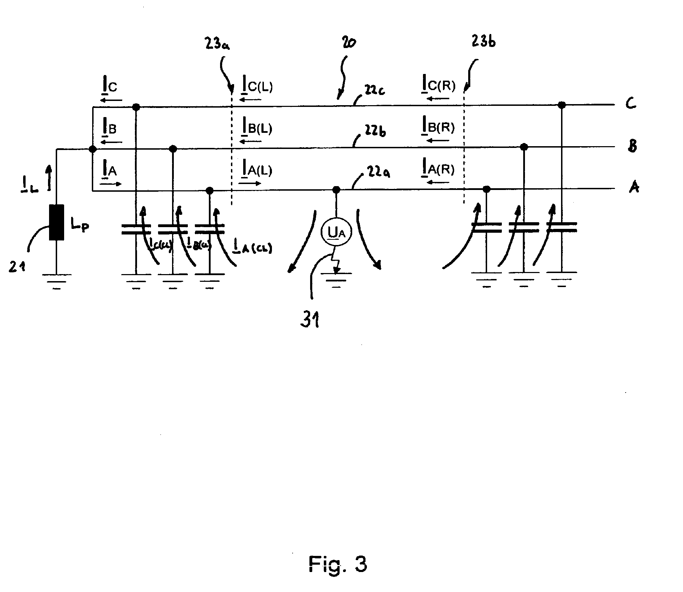

Figur 3 zeigt ein Ersatzschaltbild für einen gestörten Betrieb des gelöschten Netzes. Der durch einen Blitz symbolisierte Erdschluss 31 liegt am Phasenleiter "A" 22a des überwachten Leitungsabschnitts 20. Da beide Schutzgeräte 13a, 13b (vgl. Figur 1) in die Richtung der zu schützenden Leitung ausgerichtet sind, erkennen sie den Erdschluss 31 in Vorwärtsrichtung.

Der Erdschluss kann mathematisch als die Superposition des fehlerfreien Falls (vgl. Figur 2) mit einem fehlerbehafteten Fall beschrieben werden. Der Kurzschussstrom wird in dieser Situation durch eine "fiktive" Quelle $\underline{U}_A$ getrieben, deren Wert näherungsweise der Einspeisungsspannung des fehlerbehafteten Phasenleiters "A" 22a entspricht (unterstrichene Größen bedeuten komplexe Zahlen). Diese Situation bildet stark unsymmetrische Bedingungen nach, wobei die erwähnte Quelle $\underline{U}_A$ das Nullsystem der Spannung widerspiegelt und durch Gleichung (1) dargestellt werden kann:

$$3\underline{U}_0 = -\underline{U}_A = \underline{U}_B + \underline{U}_C \qquad\qquad (1)$$

Wie aus Figur 3 ersichtlich ist, treibt die "fiktive" Quelle $\underline{U}_A$ die Nullsystemströme in beide Richtungen. Da nicht nur die kapazitiven sondern auch die ohmschen Anteile im Netz auftreten, kann man davon ausgehen, dass in jedem Netzknoten die Nullsystem-Wirkleistung erfasst werden kann.

An der rechten Messstelle 23b wird mit dem dort vorhandenen Schutzgerät der Nullsystemstrom $3\underline{I}_{0(R)}$ gemäß Gleichung (2) erfasst:

$$3\underline{I}_{0(R)} = \underline{I}_{A(R)} + \underline{I}_{B(R)} + \underline{I}_{C(R)} \qquad\qquad (2)$$

Dieser Nullsystemstrom $3\underline{I}_{0(R)}$ hat einen stark kapazitiven Charakter, der durch die Kapazitäten ($C_{A(R)}$, $C_{B(R)}$, $C_{C(R)}$) der rechten Seite des Netzes geprägt wird. Außer kapazitiven Eigenschaften weist der Nullsystemstrom $3\underline{I}_{0(R)}$ auch die schon erwähnten ohmschen Anteile auf, die die Basis für die Richtungsbestimmung sind. Da die gemessene Nullsystemspannung ein negatives Vorzeichen hat, ist die bestimmte Nullsystem-Wirkleistung als Realteil der Scheinleistung $\underline{S}_{0(R)}$ entsprechend negativ, was sich aus folgender Gleichung (3) ergibt:

$$\mathrm{Re}(\underline{S}_{0(R)}) = \mathrm{Re}\big(3\underline{U}_0 \cdot (3\underline{I}_{0(R)})^*\big) = -\mathrm{Re}\big(\underline{U}_A \cdot (3\underline{I}_{0(R)})^*\big) < 0 \qquad (3)$$

Da das Vorzeichen der Wirkleistung negativ ist, erzeugt das Schutzgerät an der Messstelle 23b eine Richtungsinformation, die eine Vorwärtsrichtung angibt.

Am linken Messpunkt erfasst man den Nullsystemstrom $3\underline{I}_{0(L)}$ gemäß Gleichung (4):

$$3\underline{I}_{0(L)} = \underline{I}_{A(L)} - \underline{I}_{B(L)} - \underline{I}_{C(L)} \qquad (4)$$

wobei gemäß Gleichung (5) gilt:

$$\underline{I}_{A(L)} = \underline{I}_L + \underline{I}_{C(L)} + \underline{I}_{B(L)} + I_{A(CL)} + I_{B(CL)} + I_{C(CL)} \qquad (5)$$

Der Index (CL) bezeichnet hierbei die durch die von den einzelnen Leitungskapazitäten $C_{A(L)}$, $C_{B(L)}$, $C_{C(L)}$ abhängige Netzkapazität $C_{(L)}$ am linken Ende des Leitungsabschnitts 20 fließenden Ströme.

Setzt man den Strom $\underline{I}_{A(L)}$ aus Gleichung (5) in Gleichung (4) ein, erhält man den Nullsystemstrom $3\underline{I}_{0(L)}$ an der Messstelle 23a am linken Ende des Leitungsabschnitts 20 gemäß Gleichung (6):

$$3\underline{I}_{0(L)} = \underline{I}_L + \underline{I}_{C(CL)} + I_{B(CL)} + I_{C(CL)} \qquad (6)$$

Dieser Nullsystemstrom $3\underline{I}_{0(L)}$ hat einen starken induktiven Charakter, der sich aus der Kompensationsspule 21 ergibt, die eine Überkompensation eines kapazitiven Kurzschlussstromes ausführt.

Vergleichbar zur Vorgehensweise an der rechten Messstelle 23b kann die Nullsystem-Wirkleistung $\mathrm{Re}(\underline{S}_{0(L)})$ gemäß Gleichung (7) berechnet werden:

$$\mathrm{Re}(\underline{S}_{0(L)}) = \mathrm{Re}\big(3\underline{U}_0 \cdot (3\underline{I}_{0(L)})^*\big) = -\mathrm{Re}\big(\underline{U}_A \cdot (3\underline{I}_{0(L)})^*\big) < 0 \qquad (7)$$

Da auch das Vorzeichen dieser Wirkleistung negativ ist, erzeugt das Schutzgerät an der Messstelle 23a ebenfalls eine Richtungsinformation, die eine Vorwärtsrichtung angibt. Aus dem Vergleich beider Richtungsinformationen kann darauf geschlossen werden, dass der Erdschluss auf dem Leitungsabschnitt 20 vorliegt, so dass ein Fehlersignal erzeugt werden kann, dass einen sogenannten "internen" Fehler angibt.

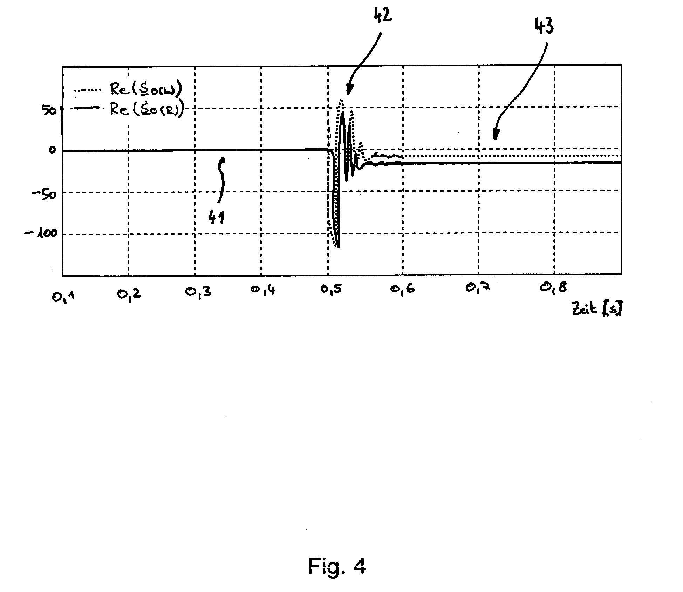

Figur 4 zeigt ein Bespiel für den zeitlichen Verlauf der Nullsystem-Wirkleistung bei einem internen Fehler. Wie Figur 4 zu entnehmen ist, tritt der Fehler bei einer Zeit von 0,5s auf. Damit lässt sich der Verlauf in 3 zeitliche Intervalle 41, 42, 43 aufteilen. In erstem Intervall 41 erkennt man einen symmetrischen ungestörten Netzzustand, in dem keine Nullsystem-Wirkleistung zu messen ist. Gleich nach dem Fehlereintritt (Intervall 42) liefert die berechnete Nullsystem-Wirkleistung unbrauchbare, da instabile Werte, die aus dem Einschwingvorgang des Netzes resultieren. Dieses Intervall 42 dauert ungefähr 0,1s, die genaue Dauer ist im Allgemeinen von der Netzauslegung und der Netzverteilung abhängig. Im Intervall 43 liefert die Bestimmung der Nullsystem-Wirkleistung schließlich brauchbare Werte, die die Richtung des Erdschlusses anzeigen. Da beide Verläufe im negativen Bereich angesiedelt sind, geben sie jeweils eine Vorwärtsrichtung an.

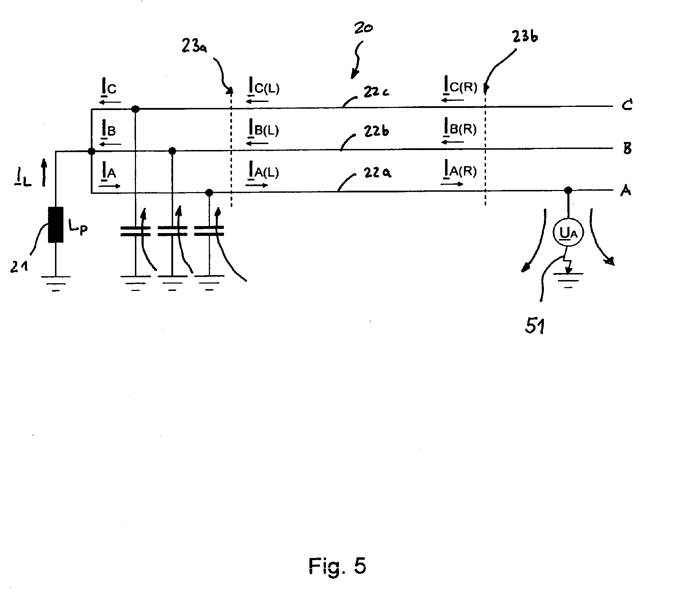

Im Beispiel entsprechend Figur 5 ist ein Erdschluss 51 außerhalb des überwachten Leitungsabschnitts 20 (ein sogenannter "externer" Fehler) dargestellt. Hier sieht das Schutzgerät an der linken Messstelle 23a den Erdschluss 51 vorwärts gerichtet und erzeugt folglich eine Richtungsinformation, die eine Vorwärtsrichtung angibt. Das Schutzgerät an der rechten Messstelle 23b sieht den Erdschluss dagegen rückwärts gerichtet und erzeugt folglich eine Richtungsinformation, die eine Rückwärtsrichtung angibt.

Aus dem Vergleich beider Richtungsinformationen kann darauf geschlossen werden, dass der Erdschluss außerhalb des Leitungsabschnitts 20 und rechts von der rechten Messstelle 23b liegen muss.

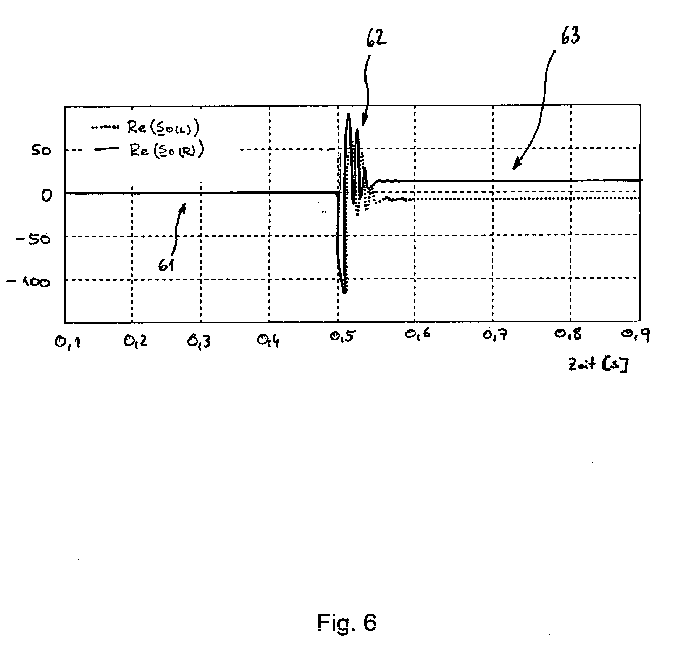

Figur 6 zeigt ein Beispiel für den zeitlichen Verlauf der Nullsystem-Wirkleistung bei einem externen Fehler. Wie Figur 6 zu entnehmen ist, setzt der Fehler bei einer Zeit von 0,5s ein. Damit lässt sich der Verlauf wiederum in 3 zeitliche Intervalle 61, 62, 63 aufteilen. In erstem Intervall 61 erkennt man einen symmetrischen ungestörten Netzzustand, in dem keine Nullsystem-Wirkleistung zu messen ist. Nach dem Fehlereintritt (Intervall 62), liefert die berechnete Nullsystem-Wirkleistung unbrauchbare, da instabile Werte, die sich aus dem Einschwingvorgang des Netzes ergeben. Im Intervall 63 liefert die Bestimmung der Nullsystem-Wirkleistung schließlich brauchbare Werte, die die Richtung des Erdschlusses anzeigen. Der im negativen Bereich liegende Verlauf gibt eine Vorwärtsrichtung an, während der im positiven Bereich liegende Verlauf eine Rückwärtsrichtung angibt. Aus dem Vergleich beider Richtungssignale kann auf einen außerhalb des Leitungsabschnitts 20 liegenden Erdschluss geschlossen und ein entsprechendes Fehlersignal für einen externen Fehler erzeugt werden.

Figur 7 zeigt ein Ersatzschaltbild für einen Leitungsabschnitt 70 eines elektrischen Energieversorgungsnetzes mit isoliertem Sternpunkt. Der Leitungsabschnitt 70 umfasst drei Phasenleiter "A" 72a, "B" 72b und "C" 72c. Auch in Figur 7 sind in bekannter Weise die Kapazitäten $C_{A(L)}$, $C_{B(L)}$, $C_{C(L)}$ an der linken Messstelle 73a und $C_{A(R)}$, $C_{B(R)}$, $C_{C(R)}$ an der rechten Messstelle 73b eingetragen. Am Phasenleiter "A" 72a liegt ein interner Erdschluss 71 vor.

Das isolierte Netz wird ohne Erdung betrieben. Auch in diesem Fall ist der Betrieb während eines einpoligen Erdschlusses möglich. Die Kurzschlussströme haben dann einen kapazitiven Charakter. Die Voraussetzung für die Fehlersuche in solchen Netzsystemen ist die Analyse der Blindleistung des Nullsystems. Der Erdschluss kann ähnlich wie bei dem gelöschten Netz als die Superposition der beiden Netzzustände (Normalbetrieb und Störungsfall) analysiert werden. Da bei dem Normalbetrieb die Nullsystemgrößen vernachlässigbar klein sind, soll nur der in Figur 7 gezeigte Störungsfall näher analysiert werden. Vergleichbar wie beim gelöschten Netz muss eine "fiktive" Quelle $\underline{U}_A$ eingeführt werden, die die Kurzschlussströme erzeugt.

An der rechten Messstelle 73b wird der Nullsystemstrom $3\underline{I}_{0(R)}$ wie in Gleichung (8) dargestellt gewonnen:

$$3\underline{I}_{0(R)} = \underline{I}_{A(R)} + \underline{I}_{B(R)} + \underline{I}_{C(R)} \tag{8}$$

Die Phasenströme der rechten Seite des Netzes können mit einer guten Annäherung auf die im Gleichungssystem (9a-9c) gefasste Art und Weise mathematisch dargestellt werden:

$$\underline{I}_{A(R)} = \underline{U}_A j\omega C_{A(R)} \tag{9a}$$

$$\underline{I}_{B(R)} = \underline{U}_A j\omega C_{B(R)} \tag{9b}$$

$$\underline{I}_{C(R)} = \underline{U}_A j\omega C_{C(R)} \tag{9c}$$

wobei $\omega$ die Grund-Kreisfrequenz des Systems ist. Hierbei wurde angenommen, dass das Netz relativ kleine Verluste besitzt, die in der Betrachtung weggelassen werden können.

Der Nullsystemstrom $3\underline{I}_{0(R)}$ kann dann wie in Gleichung (19) angegeben ausgedrückt werden:

$$3\underline{I}_{0(R)} = 3\underline{U}_A j\omega C_R \tag{10}$$

Daraus ergibt sich die Nullsystem-Blindleistung $\text{Im}(\underline{S}_{0(R)})$ gemäß Gleichung (11):

$$\text{Im}(\underline{S}_{0(R)}) = \text{Im}\left(3\underline{U}_0 \cdot \left(3\underline{I}_{0(R)}\right)^*\right) = -\text{Im}\left(3\underline{U}_A \cdot \left(3\underline{U}_A j\omega C_R\right)^*\right) = \left(9\left|\underline{U}_A\right|^2 \omega C_R\right) > 0 \tag{11}$$

Das Vorzeichen der Nullsystem-Blindleistung an der rechten Messstelle 73b ist somit positiv, so dass das entsprechende Schutzgerät eine Richtungsinformation erzeugt, die eine Vorwärtsrichtung angibt.

Für die linke Messstelle 73a kann die entsprechende Vorgehensweise durchgeführt werden. Der gemessene Nullsystemstrom $3\underline{I}_{0(L)}$ lässt sich wie in Gleichung (12) gezeigt darstellen:

$$3\underline{I}_{0(L)} = \underline{I}_{C(CL)} + I_{B(CL)} + I_{C(CL)} \tag{12}$$

Der Index (CL) bezeichnet hierbei wieder die durch die von den einzelnen Leitungskapazitäten $C_{A(L)}$, $C_{B(L)}$, $C_{C(L)}$ abhängige Netzkapazität $C_{(L)}$ am linken Ende des Leitungsabschnitts 20 fließenden Ströme.

Es ist einfach zu erkennen, dass der Nullsystemstrom $3\underline{I}_{0(L}$ einen kapazitiven Charakter besitzt. Der Nullsystemstrom lässt sich gemäß Gleichung (13) explizit von der Spannung $\underline{U}_A$ an der Fehlerstelle und von der Netzkapazität $C_{(L)}$ abhängig machen:

$$3\underline{I}_{0(L)} = 3\underline{U}_A j\omega C_{(L)} \qquad (13)$$

Damit ist die Nullsystem-Blindleistung $Im(\underline{S}_{0(L)})$ auf in Gleichung (14) gezeigte Art und Weise zu definieren:

$$Im(\underline{S}_{0(L)}) = Im\left(3\underline{U}_0 \cdot (3\underline{I}_{0(L)})^*\right) = -Im\left(3\underline{U}_A \cdot (\underline{U}_A j\omega C_L)^*\right) = \left(9|\underline{U}_A|^2 \omega C_L\right) > 0 \qquad (14)$$

Die Nullsystem-Blindleistung besitzt folglich ein positives Vorzeichen, so dass das Schutzgerät an der linken Messstelle 73a eine Richtungsinformation erzeugt, die eine Vorwärtsrichtung angibt.

Aus dem Vergleich beider Richtungssignale kann auf einen internen Fehler auf dem überwachten Leitungsabschnitt 70 geschlossen werden.

Aus der voranstehenden mathematischen Betrachtung lässt sich außerdem für einen externen Fehler der folgende Rückschluss ziehen: Wenn der Erdschluss rechts von der rechten Messstelle liegen sollte, würde das linke Schutzgerät eine Vorwärtsrichtung ermitteln, dagegen wird sich das rechte Schutzgerät für eine Rückwärtsrichtung entscheiden, weil es einen Nullsystemstrom mit einem negativen Vorzeichen ermitteln wird. Falls der Erdschluss links von der linken Messstelle liegen sollte, wäre die Situation entsprechend umgekehrt. Das linke Schutzgerät würde den Fehler in Rückwärtsrichtung sehen, hingegen ist der Fehler vom rechten Schutzgerät in Vorwärtsrichtung zu interpretieren.

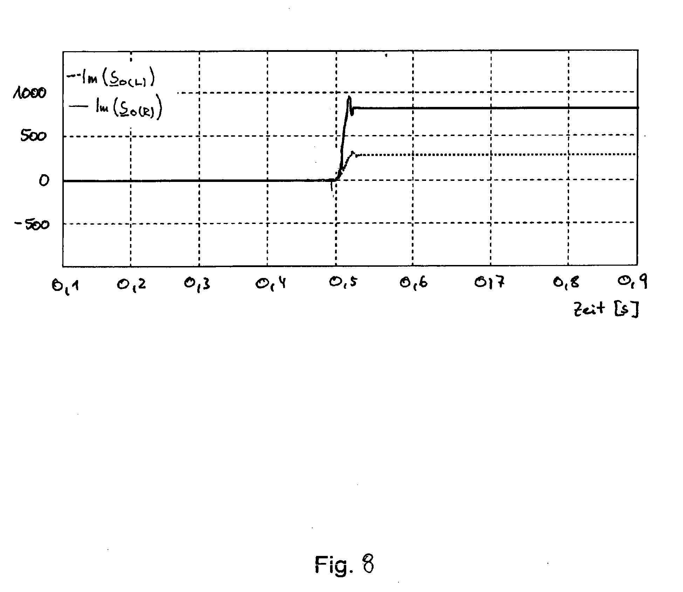

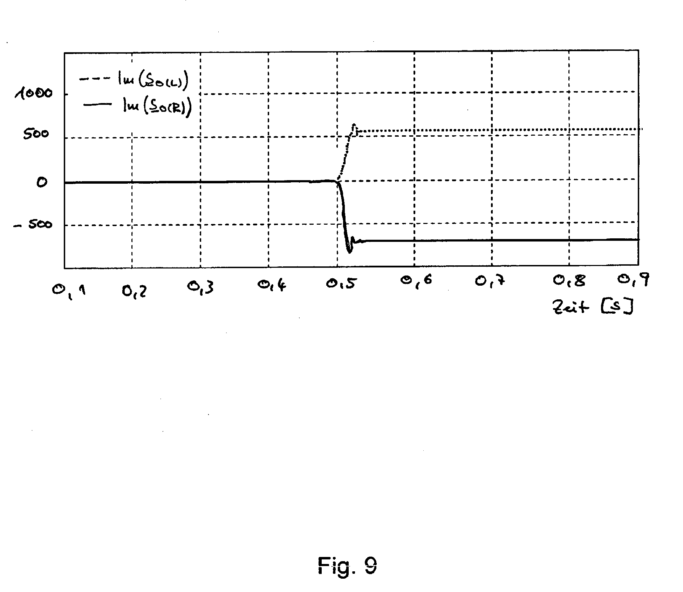

In Figuren 8 und 9 wurden Beispiele für den zeitlichen Verlauf der Nullsystem-Blindleistung jeweils für einen internen Fehler (Figur 8) und einen externen Fehler (Figur 9) dargestellt. Vergleichbar wie bei dem gelöschten Netz kann der Verlauf jeweils in drei Intervalle aufgeteilt werden. Im ersten Intervall bis 0,5s weist die Nullsystem-Blindleistung vernachlässigbar kleine Werte auf, die davon zeugen, dass das Netz symmetrisch und störungsfrei betrieben wird. Nach 0,5s startet der Erdschluss, der einen plötzlichen Anstieg der Nullsystem-Blindleistung bewirkt. Während einer gewissen Zeit erfolgt eine Schwankung der gemessenen Nullsystem-Blindleistung, was sich aus dem Ausgleichsvorgang nach dem Fehlereintritt ergibt. Erst nach diesem Ausgleichsvorgang erreichen die Werte der Nullsystem-Blindleistung stabile Pegel. Basierend auf den erreichten Werten, lässt sich Fehlerrichtung ermitteln.

In Figur 8 liegen die Werte der Nullsystem-Blindleistung für beide Messstellen nach dem Fehlereintritt im positiven Bereich, so dass die Schutzgeräte an beiden Enden des Leitungsabschnitts einen Fehler in der Vorwärtsrichtung erkennen und entsprechend ein Fehlersignal erzeugt wird, das einen internen Fehler angibt. In Figur 9 hingegen liegt der Wert für die Nullsystem-Blindleistung für die linke Messstelle im positiven Bereich und führt bei dem dortigen Schutzgerät zur Erzeugung einer Richtungsinformation, die eine Vorwärtsrichtung angibt, während der Wert für die Nullsystem-Blindleistung für die rechte Messstelle im negativen Bereich liegt, so dass das dortige Schutzgeräte einen Fehler in der Rückwärtsrichtung erkennt. Aus dem Vergleich beider Richtungsinformationen kann ein Fehlersignal abgeleitet werden, dass einen externen Fehler rechts von der rechten Messstelle angibt.

Um die Nullsystem-Wirkleistung bzw. die Nullsystem-Blindleistung zu erfassen, müssen die an den Messstellen jeweils gemessen Nullsystemströme und Nullsystemspannungen in Form von komplexen Zeigern mathematisch beschrieben werden. Die Umwandlung der zeitlichen Verläufe in komplexe Zeiger erfolgt durch den Einsatz von zwei Filtern, die jeweils den Real- und den Imaginärteil des Messsignals liefern. Die beiden Filter müssen auf die Grundfrequenz des Energieversorgungsnetzes abgestimmt werden, weil nur die Nullsystem-Wirkleistung bzw. Nullsystem-Blindleistung der Grundfrequenz aussagekräftig über die Richtung des Erdschlusses ist. Aus beiden gewonnen Zeigern wird durch Multiplikation die komplexe Nullsystem-Scheinleistung gebildet, wobei zur Bestimmung der Nullsystem-Wirkleistung nur deren Realteil weiterhin analysiert werden darf. Zur Bestimmung der Nullsystem-Blindleistung muss hingegen der Imaginärteil der komplexen Nullsystem-Scheinleistung ausgewertet wird.

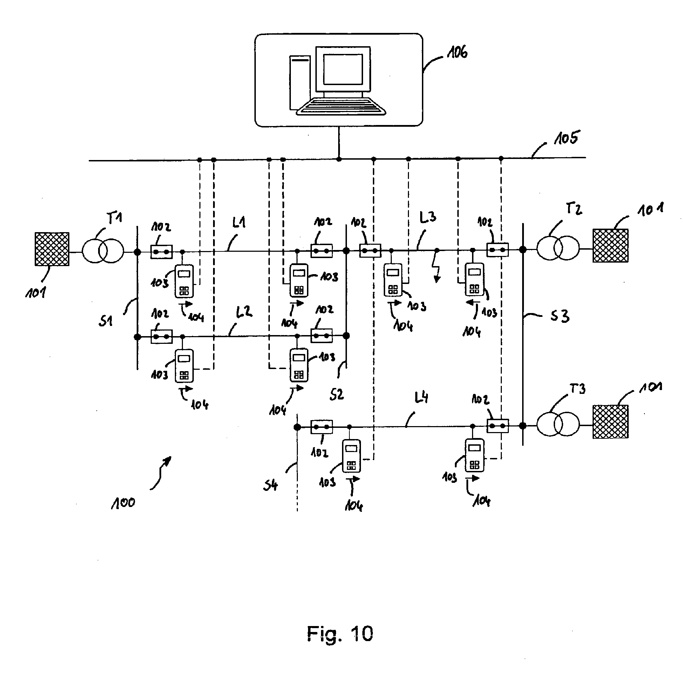

In Figur 10 ist schließlich ein Teil eines komplexen isolierten Energieversorgungsnetzes 100 dargestellt. Das gezeigte Energieversorgungsnetz umfasst Sammelschienen S1, S2, S3 und S4, die über Leitungsabschnitte L1, L2, L3 und L4 miteinander verbunden sind. So bilden Leitungsabschnitte L1 und L2 Parallelleitungen zwischen den Sammelschienen S1 und S2, während Sammelschienen S2 und S3 über den Leitungsabschnitt L3, und Sammelschienen S3 und S4 über den Leitungsabschnitt L4 verbunden sind. Sammelschiene S4 ist im Übrigen nur teilweise dargestellt und kann mit weiteren Netzteilen des Energieversorgungsnetzes 100 in Verbindung stehen.

Die Sammelschienen S1 und S3 stehen außerdem über Transformatorstationen T1, T2 und T3 mit Einspeisestellen 101 in Verbindung.

Jeder Leitungsabschnitt L1 bis L4 ist an seinen beiden Enden mit Leistungsschaltern 102 ausgestattet, die im Fehlerfall den fehlerbehafteten Leitungsabschnitt vom übrigen Energieversorgungsnetz 100 abtrennen. Dazu sind an jedem Ende der Leitungsabschnitte L1 bis L4 an Messstellen Schutzgeräte 103 vorgesehen, die eine Überwachung der Leitungsabschnitte L1 bis L4 vornehmen. Bei den Schutzgeräten 103 kann es sich beispielsweise um Differentialschutzgeräte handeln, allerdings können auch Schutzgeräte eingesetzt werden, die eine Überwachung nach einem anderen Schutzprinzip (z.B. Überstromschutz, Distanzschutz) durchführen. Erkennen die Schutzgeräte 103 auf ihrem Leitungsabschnitt L1 bis L4 einen schwerwiegenden Fehler, z.B. einen mehrpoligen Erdschluss, so muss der betreffende Leitungsabschnitt über die zugehörigen Leistungsschalter 102 vom restlichen Energieversorgungsnetz 100 getrennt werden.

Im Falle eines Einfach-Erdschlusses kann das isolierte Netz jedoch wie bereits beschrieben weiterbetrieben werden, jedoch muss der Einfach-Erdschluss erkannt und einem Leitungsabschnitt zugeordnet werden.

Hierfür führen die Schutzgeräte 103 das bereits beschriebene Verfahren zur Erkennung eines Einfach-Erdschlusses in einem isolierten Energieversorgungsnetz aus und bilden entsprechend der ermittelten Nullsystem-Blindleistung die jeweiligen Richtungsinformationen.

Im Ausführungsbeispiel von Figur 10 sei angenommen, dass an einer Phase des Leitungsabschnitts L3 ein Einfach-Erdschluss aufgetreten ist. Die Schutzgeräte 103 erzeugen für diesen Fall Richtungsinformationen entsprechend der beispielhaft angegebenen Pfeile 104, die jeweils in die Richtung des Fehlers weisen. Während für die Leitungsabschnitte L1, L2 und L4 jeweils eine Vorwärts- und eine Rückwärtsrichtung angegeben wird, geben die Schutzgeräte 103 am Leitungsabschnitt L3 zwei Vorwärtsrichtungen an. Die Richtungsinformationen der einzelnen Schutzgeräte 103 können über ein Kommunikationssystem 105, z.B. einen Systembus, des Energieversorgungsnetzes 100 an eine übergeordnete Datenverarbeitungseinrichtung 106 einer Netzleitstelle oder einer Stationsleitstelle übertragen werden. Die übergeordnete Datenverarbeitungseinrichtung 106 ermittelt durch Vergleich der jeweiligen Richtungsinformationen den fehlerbehafteten Leitungsabschnitt L3 und gibt an den Netzbetreiber ein entsprechendes Fehlersignal, z.B. eine optische Fehlermeldung, aus, so dass der Netzbetreiber die Fehlerstelle untersuchen und den Erdschluss beheben lassen kann.

Wie weiter vorn bereits beschrieben, kann alternativ zur Übertragung der Richtungsinformationen an die übergeordnete Datenverarbeitungseinrichtung 106 auch eine Übertragung der Richtungsinformationen an ein oder mehrere der Schutzgeräte 103 erfolgen, so dass das entsprechende Schutzgerät (oder die entsprechenden Schutzgeräte) die Auswertung vornehmen und den fehlerbehafteten Leitungsabschnitt L3 ermitteln.

**Patentansprüche**

1.    Verfahren zum Bestimmen eines erdschlussbehafteten Leitungsabschnitts (10) in einem dreiphasigen elektrischen Energieversorgungsnetz mit isoliertem oder gelöschtem Sternpunkt, bei dem

- an beiden Enden des Leitungsabschnitts (10) an jeweils einer Messstelle (12a, 12b) mittels elektrischer Schutzgeräte (13a, 13b) eine Nullsystemspannung und ein Nullsystemstrom erfasst werden; und
- aus der Nullsystemspannung und dem Nullsystemstrom eine Richtungsinformation gewonnen wird, die angibt, ob ein Erdschluss in Vorwärts- oder in Rückwärtsrichtung bezüglich der jeweiligen Messstelle (12a, 12b) liegt;
**dadurch gekennzeichnet, dass**
- mit den Schutzgeräten (13a, 13b) an beiden Enden des Leitungsabschnitts (10) aus der Nullsystemspannung und dem Nullsystemstrom eine komplexe Nullsystem-Scheinleistung bestimmt wird;
- aus dem Vorzeichen eines Anteils der komplexen Nullsystem-Scheinleistung die Richtungsinformation abgeleitet wird;
- die Richtungsinformationen von beiden Enden miteinander verglichen werden; und
- ein auf dem Leitungsabschnitt (10) liegender Erdschluss erkannt wird, wenn beide Richtungsinformationen eine Vorwärtsrichtung angeben und ein außerhalb des Leitungsabschnitts (10) liegender Erdschluss erkannt wird, wenn zumindest eine Richtungsinformation eine Rückwärtsrichtung angibt.

2.    Verfahren nach Anspruch 1,
**dadurch gekennzeichnet, dass**

- bei einem Energieversorgungsnetz mit isoliertem Sternpunkt die jeweilige Richtungsinformation gebildet wird, indem der Imaginärteil der Nullsystem-Scheinleistung unter Bildung einer Nullsystem-Blindleistung bestimmt wird; und
- bei positivem Vorzeichen der Nullsystem-Blindleistung die Vorwärtsrichtung erkannt wird und bei negativem Vorzeichen der Nullsystem-Blindleistung die Rückwärtsrichtung erkannt wird.

**3.** Verfahren nach Anspruch 1,
**dadurch gekennzeichnet, dass**

- bei einem Energieversorgungsnetz mit gelöschtem Sternpunkt die jeweilige Richtungsinformation gebildet wird, indem der Realteil der Nullsystem-Scheinleistung unter Bildung einer Nullsystem-Wirkleistung bestimmt wird; und
- bei negativem Vorzeichen der Nullsystem-Wirkleistung die Vorwärtsrichtung erkannt wird und bei positivem Vorzeichen der Nullsystem-Wirkleistung die Rückwärtsrichtung erkannt wird.

**4.** Verfahren nach einem der vorangehenden Ansprüche,
**dadurch gekennzeichnet, dass**

- die Richtungsinformationen beider Enden an eine übergeordnete Datenverarbeitungseinrichtung (18) übertragen werden; und
- die übergeordnete Datenverarbeitungseinrichtung (18) den Vergleich der Richtungsinformationen durchführt und ein Fehlersignal abgibt, das einen auf dem Leitungsabschnitt (10) oder außerhalb des Leitungsabschnitts (10) liegenden Erdschluss angibt.

**5.** Verfahren nach einem der Ansprüche 1 bis 3,
**dadurch gekennzeichnet, dass**

- an ein ausgewähltes der beiden Schutzgeräte (z.B. 13a) die Richtungsinformation des anderen Schutzgerätes (z.B. 13b) übertragen wird; und
- das ausgewählte Schutzgerät (z.B. 13a) den Vergleich der Richtungsinformationen durchführt und ein Fehlersignal abgibt, das einen auf dem Leitungsabschnitt (10) oder außerhalb des Leitungsabschnitts (10) liegenden Erdschluss angibt.

**6.** Verfahren nach einem der Ansprüche 1 bis 3,
**dadurch gekennzeichnet, dass**

- beide Richtungsinformationen zu dem jeweiligen Schutzgerät (13a, 13b) am gegenüberliegenden Ende des Leitungsabschnitts (10) übertragen werden; und
- jedes Schutzgerät (13a, 13b) den Vergleich der Richtungsinformationen durchführt und ein Fehlersignal abgibt, das einen auf dem Leitungsabschnitt (10) oder außerhalb des Leitungsabschnitts (10) liegenden Erdschluss angibt.

**7.** Verfahren nach Anspruch 5 oder 6,
**dadurch gekennzeichnet, dass**

- die Schutzgeräte (13a, 13b) Differentialschutzgeräte sind; und
- zur Übertragung der jeweiligen Richtungsinformation eine ohnehin zur Durchführung des Differentialschutzes vorhandene Datenübertragungsleitung (14) verwendet wird.

**8.** Verfahren nach einem der vorangehenden Ansprüche,
**dadurch gekennzeichnet, dass**

- bei einem elektrischen Energieversorgungsnetz (100) mit mehreren Leitungsabschnitten (L1, L2, L3, L4) für jedes Ende eines jeden Leitungsabschnitts (L1, L2, L3, L4) die Richtungsinformation gebildet wird; und
- aus einem Vergleich aller Richtungsinformation derjenige Leitungsabschnitt (z.B. L3) als von dem Erdschluss behaftet angegeben wird, an dessen Enden die Richtungsinformationen jeweils eine Vorwärtsrichtung angeben.

**9.** Elektrisches Schutzgerät (z.B. 13a), das zur Überwachung eines Leitungsabschnitts (10) eines dreiphasigen elektrischen Energieversorgungsnetzes an einer Messstelle (z.B. 12a) an einem Ende des Leitungsabschnitts (10) angeordnet ist, mit

- einer Messeinrichtung zur Erfassung einer Nullsystemspannung und eines Nullsystemstroms an der Messstelle;
**gekennzeichnet durch**

- eine Auswertungseinrichtung, die zur Bestimmung einer Richtungsinformation entsprechend einem Verfahren gemäß einem der Ansprüche 1 bis 3 eingerichtet ist.

**10.** Elektrisches Schutzgerät (z.B. 13a) nach Anspruch 9,
**dadurch gekennzeichnet, dass**

- es eine Kommunikationseinrichtung aufweist, die zur Übertragung einer Richtungsinformation an ein anderes elektrisches Schutzgerät (z.B. 13b) oder eine übergeordnete Datenverarbeitungseinrichtung (18) eingerichtet ist.

**11.** Elektrisches Schutzgerät (z.B. 13a) nach Anspruch 9 oder 10,
**dadurch gekennzeichnet, dass**

- es eine Kommunikationseinrichtung aufweist, die zum Empfang einer Richtungsinformation von einem anderen elektrischen Schutzgerät (z.B. 13b) eingerichtet ist; und
- die Auswertungseinrichtung zum Vergleich der eigenen und der empfangenen Richtungsinformation und zur Bildung eines Fehlersignals eingerichtet ist, wobei das Fehlersignal einen auf dem Leitungsabschnitt (10) oder außerhalb des Leitungsabschnitts (10) liegenden Erdschluss angibt.

**12.** Elektrisches Schutzgerät (z.B. 13a) nach Anspruch 10 oder 11,
**dadurch gekennzeichnet, dass**

- das Schutzgerät (13a) ein Differentialschutzgerät ist; und
- die Kommunikationseinrichtung zur Übertragung oder zum Empfang einer Richtungsinformation mit einer ohnehin zur Durchführung des Differentialschutzes vorhandenen Datenübertragungsleitung (14) in Verbindung steht.

**Claims**

**1.** Method for determining an earth-faulted line section (10) in a three-phase electrical energy supply network with an insulated or a resonant-earthed star point, in which

- a zero phase-sequence system voltage and a zero phase-sequence system current are recorded at both ends of the line section (10) at a respective measuring point (12a, 12b) using electrical protective devices (13a, 13b); and
- an item of direction information is obtained from the zero phase-sequence system voltage and the zero phase-sequence system current, which item of direction information indicates whether there is an earth fault in the forward direction or reverse direction with respect to the respective measuring point (12a, 12b);
**characterized in that**
- a complex zero phase-sequence system apparent power is determined from the zero phase-sequence system voltage and the zero phase-sequence system current using the protective devices (13a, 13b) at both ends of the line section (10);
- the item of direction information is derived from the sign of a portion of the complex zero phase-sequence system apparent power;
- the items of direction information from both ends are compared with one another; and
- an earth fault on the line section (10) is detected if both items of direction information indicate a forward direction, and an earth fault outside the line section (10) is detected if at least one item of direction information indicates a reverse direction.

**2.** Method according to Claim 1,
**characterized in that**

- in the case of an energy supply network with an insulated star point, the respective item of direction information is formed by determining the imaginary part of the zero phase-sequence system apparent power by forming a zero phase-sequence system reactive power; and
- the forward direction is detected for a positive sign of the zero phase-sequence system reactive power, and the reverse direction is detected for a negative sign of the zero phase-sequence system reactive power.

3.  Method according to Claim 1,
    **characterized in that**

    - in the case of an energy supply network with a resonant-earthed star point, the respective item of direction information is formed by determining the real part of the zero phase-sequence system apparent power by forming a zero phase-sequence system active power; and
    - the forward direction is detected for a negative sign of the zero phase-sequence system active power, and the reverse direction is detected for a positive sign of the zero phase-sequence system active power.

4.  Method according to one of the preceding claims,
    **characterized in that**

    - the items of direction information from both ends are transmitted to a superordinate data processing device (18); and
    - the superordinate data processing device (18) compares the items of direction information and emits an error signal which indicates an earth fault on the line section (10) or outside the line section (10).

5.  Method according to one of Claims 1 to 3,
    **characterized in that**

    - the item of direction information from the other protective device (for example 13b) is transmitted to a selected one of the two protective devices (for example 13a); and
    - the selected protective device (for example 13a) compares the items of direction information and emits an error signal which indicates an earth fault on the line section (10) or outside the line section (10).

6.  Method according to one of Claims 1 to 3,
    **characterized in that**

    - both items of direction information are transmitted to the respective protective device (13a, 13b) at the opposite end of the line section (10); and
    - each protective device (13a, 13b) compares the items of direction information and emits an error signal which indicates an earth fault on the line section (10) or outside the line section (10).

7.  Method according to Claim 5 or 6,
    **characterized in that**

    - the protective devices (13a, 13b) are differential protective devices; and
    - a data transmission line (14) which is present anyway in order to carry out the differential protection is used to transmit the respective item of direction information.

8.  Method according to one of the preceding claims,
    **characterized in that**

    - in an electrical energy supply network (100) having a plurality of line sections (L1, L2, L3, L4), the item of direction information is formed for each end of each line section (L1, L2, L3, L4); and
    - and that line section (for example L3), at whose ends the items of direction information each indicate a forward direction, is indicated as earth-faulted from a comparison of all direction information.

9.  Electrical protective device (for example 13a) which, in order to monitor a line section (10) of a three-phase electrical energy supply network, is arranged at a measuring point (for example 12a) at one end of the line section (10), having

    - a measuring device for recording a zero phase-sequence system voltage and a zero phase-sequence system current at the measuring point;
    **characterized by**
    - an evaluation device which is set up to determine an item of direction information in accordance with a method according to one of Claims 1 to 3.

10. Electrical protective device (for example 13a) according to Claim 9,

**characterized in that**

> - it has a communication device which is set up to transmit an item of direction information to another electrical protective device (for example 13b) or to a superordinate data processing device (18).

**11.** Electrical protective device (for example 13a) according to Claim 9 or 10,
**characterized in that**

> - it has a communication device which is set up to receive an item of direction information from another electrical protective device (for example 13b); and
> - the evaluation device is set up to compare its own item of direction information and the received item of direction information and to form an error signal, the error signal indicating an earth fault on the line section (10) or outside the line section (10).

**12.** Electrical protective device (for example 13a) according to Claim 10 or 11,
**characterized in that**

> - the protective device (13a) is a differential protective device; and
> - the communication device is connected to a data transmission line (14), which is present anyway in order to carry out the differential protection, for the purpose of transmitting or receiving an item of direction information.

**Revendications**

**1.** Procédé de détermination d'un tronçon (10) de ligne ayant une fuite de terre dans un réseau d'alimentation en énergie électrique triphasé, ayant un point neutre isolé ou une disparition du point neutre, dans lequel

> - on reconnaît une tension de système homopolaire et un courant de système homopolaire aux deux extrémités du tronçon (10) de ligne en respectivement un point (12a, 12b) de mesure au moyen d'appareils (13a, 13b) de protection électrique ; et
> - on obtient, à partir de la tension de système homopolaire et du courant de système homopolaire, une information de sens, qui indique s'il y a une fuite de terre dans le sens en avant ou dans le sens en arrière par rapport au point (12a, 12b) de mesure respectif ;
> **caractérisé en ce que**
> - par les appareils (13a, 13b) de protection aux deux extrémités du tronçon (10) de ligne, on détermine une puissance apparente complexe de système homopolaire à partir de la tension de système homopolaire et du courant de système homopolaire ;
> - on déduit l'information de sens à partir du signe d'une composante de la puissance apparente complexe de système homopolaire ;
> - on compare entre elles les informations de sens des deux extrémités ; et
> - on reconnaît une fuite de terre sur le tronçon (10) de ligne, si les deux informations de sens indiquent un sens vers l'avant, et on reconnaît une fuite de terre à l'extérieur du tronçon (10) de ligne, si au moins une information de sens indique un sens vers l'arrière.

**2.** Procédé suivant la revendication 1,
**caractérisé en ce que**

> - pour un réseau d'alimentation en énergie ayant un point neutre isolé, on forme l'information de sens respective en déterminant la partie imaginaire de la puissance apparente de système homopolaire en formant une puissance apparente de système homopolaire ; et
> - si la puissance apparente de système homopolaire a un signe positif, on reconnaît le sens vers l'avant et, si la puissance apparente de système homopolaire a un signe négatif, on reconnaît un sens vers l'arrière.

**3.** Procédé suivant la revendication 1,
**caractérisé en ce que**

> - pour un réseau d'alimentation en énergie ayant une disparition du point neutre, on forme l'information de sens respective en déterminant la partie réelle de la puissance apparente de système homopolaire en formant une puissance active de système homopolaire ; et
- si la puissance active de système homopolaire a un signe négatif, on reconnaît le sens vers l'avant et, si la puissance active de système homopolaire a un signe positif, on reconnaît le sens vers l'arrière.

4. Procédé suivant l'une des revendications précédentes, **caractérisé en ce que**

- on transmet les informations de sens des deux extrémités à un dispositif (18) de traitement de données supérieures hiérarchiquement ; et
- le dispositif (18) de traitement de données supérieures hiérarchiquement effectue la comparaison des informations de sens et émet un signal de défaut, qui indique une fuite de terre sur le tronçon (10) de ligne ou à l'extérieur du tronçon (10) de ligne.

5. Procédé suivant l'une des revendications 1 à 3,
**caractérisé en ce que**

- on transmet, à l'un sélectionné des deux appareils (par exemple 13a) de protection, l'information de sens de l'autre appareil (par exemple 13b) de protection ; et
- l'appareil (par exemple 13a) de protection sélectionné effectue la comparaison des informations de sens et émet un signal de défaut, qui indique une fuite de terre sur le tronçon (10) de ligne ou à l'extérieur du tronçon (10) de ligne.

6. Procédé suivant l'une des revendications 1 à 3,
**caractérisé en ce que**

- on transmet les deux informations de sens à l'appareil (13a, 13b) de protection respectif à l'extrémité opposée du tronçon (10) de ligne ; et
- chaque appareil (13a, 13b) de protection effectue la comparaison des informations de sens et émet un signal de défaut, qui indique une fuite de terre sur le tronçon (10) de ligne ou à l'extérieur du tronçon (10) de ligne.

7. Procédé suivant la revendication 5 ou 6,
**caractérisé en ce que**

- les appareils (13a, 13b) de protection sont des appareils de protection différentielle ; et
- on utilise, pour la transmission de l'information de sens respective, une ligne (14) de transmission de données, présente de toute façon pour effectuer la protection différentielle.

8. Procédé suivant l'une des revendications précédentes, **caractérisé en ce que**

- pour un réseau (100) d'alimentation en énergie électrique ayant plusieurs tronçons (L1, L2, L3, L4) de ligne, on forme l'information de sens pour chaque extrémité de chaque tronçon (K1, L2, L3, L4) de ligne ; et
- à partir d'une comparaison entre toutes les informations de sens, on indique, comme souffrant d'une fuite de terre, le tronçon (par exemple L3) de ligne aux extrémités duquel les informations de sens indiquent respectivement un sens vers l'avant.

9. Appareil (par exemple 13a) de protection électrique, qui, pour le contrôle d'un tronçon (10) de ligne d'un système d'alimentation en énergie électrique triphasé, est mis en un point (par exemple 12a) de mesure à une extrémité du tronçon (10) de ligne, comprenant

- un dispositif de mesure pour la détection d'une tension de système homopolaire et d'un courant de système homopolaire au point de mesure ;
**caractérisé par**
- un dispositif d'exploitation, qui est conçu pour la détermination d'une information de sens conformément à un procédé suivant l'une des revendications 1 à 3.

10. Appareil (par exemple 13a) de protection électrique suivant la revendication 9,
**caractérisé en ce que**

- il a un dispositif de communication, qui est conçu pour la transmission d'une information de sens à un autre appareil (par exemple 13b) de protection électrique ou à un dispositif (18) de traitement de données supérieures hiérarchiquement.

11. Appareil (par exemple 13a) de protection électrique suivant la revendication 9 ou 10, **caractérisé en ce que**

- il a un dispositif de communication, qui est conçu pour la réception d'une information de sens par un autre appareil (par exemple 13b) de protection électrique ; et
- le dispositif d'exploitation est conçu pour comparer l'information de sens propre et l'information de sens reçue et pour former un signal de défaut, le signal de défaut indiquant une fuite de terre sur le tronçon (10) de ligne ou à l'extérieur du tronçon (10) de ligne.

12. Appareil (par exemple 13a) de protection électrique suivant la revendication 10 ou 11, **caractérisé en ce que**

- l'appareil (13a) de protection est un appareil de protection différentielle ; et
- le dispositif de communication est, pour la transmission ou pour la réception d'une information de sens, en liaison avec une ligne (14) de transmission de données, présente de toute façon pour effectuer la protection différentielle.

Fig. 1

Fig. 2

Fig. 3

Fig. 4

Fig. 5

Fig. 6

Fig. 7

Fig. 8

Fig. 9

Fig. 10

**IN DER BESCHREIBUNG AUFGEFÜHRTE DOKUMENTE**

**In der Beschreibung aufgeführte Patentdokumente**

- EP 144675 B1

**In der Beschreibung aufgeführte Nicht-Patentliteratur**

- Kurzzeitig niederohmige Sternpunkt-Schaltung. **W. DOEMELAND.** Schutztechnik - Grundlagen, Schutzsysteme, Inbetriebsetzung. VDE Verlag, 1997, vol. 6, 341